# EUROPEAN PATENT APPLICATION

(11) **EP 1 001 455 A1**
(43) Date of publication of application: **17.05.2000**
(21) Application number: 99122017.9
(22) Date of filing: 12.11.1999
(51) Int. Cl.: H01L 21/00, H01L 21/68

(54) **Apparatus for protecting a substrate support surface and method of fabricating same**

(30) Priority: 12.11.1998 US 191252
(71) Applicant: APPLIED MATERIALS, INC., Santa Clara, California 95054-3299 (US)
(72) Inventor: Xu, Zheng, Foster City, CA 94404 (US); Parkhe, Vijay, San Jose, CA 95135 (US); Tzou, Eugene, Sunnyvale, CA 94086 (US)
(74) Representative: Kahler, Kurt, Dipl.-Ing.

(57) **Abstract**

A ceramic substrate chuck having a protective coating (100) and spacing mask (110) deposited upon a support surface (102) thereof and a method of fabricating same. The protective coating (100) is fabricated of a leaky dielectric material, such materials include oxides and nitrides such as Si₃N₄, SiO₂, Si-O-N, BN, diamond, Al₂O₃, and aluminosilicates. The protective coating (100) and spacing mask (110) is formed upon the support surface (102) using one of a variety of material deposition techniques including chemical vapor deposition (CVD), plasma enhanced CVD, sputtering, flame spraying, and the like. Prior to deposition of the protective coating (100), a layer of the surface of the ceramic substrate support can be removed to reduce or prevent contaminants from being sealed between the support surface (102) and the protective coating (100). The protective coating (100) of the present invention results in a substantial decrease in contamination of ceramic chucks, wafers and the process chamber environment. The protective coating (100) does not significantly interfere with the clamping process or impact the clamping force that retains the wafer (112) upon the electrostatic chuck (104).

## Description

### BACKGROUND OF THE INVENTION

### 1. Field of the Invention

The invention relates to a ceramic substrate support chuck for supporting a semiconductor wafer within a semiconductor processing system. More particularly, the invention relates to a protective coating and spacing mask, and method of fabricating same, disposed upon a surface of the ceramic substrate support chuck for preventing reaction of the surface with contaminants and preserving the surface chemistry of the chuck.

### 2. Description of the Background Art

Substrate support chucks are widely used to support substrates within semiconductor processing systems. A particular type of chuck used in high temperature semiconductor processing systems such as high temperature, physical vapor deposition (PVD) is a ceramic electrostatic chuck. These chucks are used to retain semiconductor wafers, or other workpieces, in a stationary position in the process chamber during processing. Such electrostatic chucks contain one or more electrodes embedded within a ceramic chuck body. The ceramic chuck body is, for example, fabricated of aluminum-nitride or boron-nitride or alumina doped with a metal oxide such as titanium-oxide or chromium-oxide or some other ceramic material with similar resistive properties. This form of ceramic may also be classified as a leaky dielectric as it becomes is partially conductive at high temperatures.

In use, a wafer rests against a support surface of the chuck body as a chucking voltage is applied to the electrodes. The wafer is retained against the ceramic support by creating a return path for the chucking voltage through the wafer. That is, the electrodes and wafer are oppositely biased and insulated from each other via the chuck body. As such, equal and opposite electrostatic forces pull the wafer to the support surface.

One disadvantage of using a chuck body fabricated from ceramic is that the characteristics of the support surface change over time. During processing, the support surface is exposed to organic material. Specifically, adventitious (surface) carbon, water, and hydroxides collect on the support surface. Such contaminants enter the chamber during wafer processing as wafers are passed from a loadlock to the chamber or when the chamber is exposed to the atmosphere during a maintenance cycle. Additionally, outgassing of chamber components produces hydrocarbon contaminants, e.g., O-rings inside the chamber breakdown and outgas. These contaminants react and a conductive carbon film grows on the support surface. After repetitive processing and/or maintenance cycles, the conductive carbon film grows on the support surface to the point where it degrades chuck performance. Similarly, ceramic substrate support chucks that are used in low temperature processing (e.g., less than 300°C) are also prone to such support surface contamination and degradation of chuck performance over long periods of time (e.g., approximately six months of use).

Another disadvantage of using a chuck body fabricated from a ceramic material is realized during manufacture of the chuck. Specifically, the sintering process used to fabricate a ceramic chuck results in "grains" of ceramic material that can be easily "pulled out" of the support surface. After sintering, the ceramic material is "lapped" to produce a relatively smooth support surface. Such lapping may fracture the support surface producing particles that adhere to and become trapped in pores on the support surface. These particles are very difficult to completely remove from the support surface. Consequently, as the chuck is used, particles are continuously produced by these fractures. Empirical data shows that tens of thousands of contaminant particles may be found on the backside of a given wafer after retention upon a ceramic electrostatic chuck. The term "sticking coefficient" is used to describe the characteristic of contaminant particles from the ceramic electrostatic chuck "sticking" to the wafer. The smaller the sticking coefficient, the lesser the likelihood of particle transfer.

Also, during wafer processing, the ceramic material can abrade the wafer oxide from the underside of the wafer, resulting in further introduction of contaminants to the process environment. During use of the chuck, the particles and/or ceramic grains can adhere themselves to the underside of the wafer and be carried to other process chambers or cause defects in the circuitry fabricated upon the wafer. Furthermore, other contaminants, such as waste products from wafer processing (e.g., water and carbon), react with or form nucleation sites on the support surface causing additional contamination. Although, these process waste products are not considered principle contaminants, the cumulative buildup, after repeated processing and maintenance cycles, of these and all other contaminants with the conductive carbon film, dramatically reduce chuck performance. Consequently, the chuck is rendered useless, i.e., the chucking force is severely degraded and/or non-uniform, which results in premature replacement of the chuck, thus, increasing unit cost and chamber downtime.

Therefore, a need exists in the art for an apparatus and method that isolates the support surface of the ceramic chuck from the chamber atmosphere preventing surface reaction with contaminants, while preserving the surface chemistry of the ceramic chuck and reducing the sticking coefficient of a ceramic chuck.

### SUMMARY OF THE INVENTION

The disadvantages associated with the prior art are overcome by the present invention of a protective coating and spacing mask deposited upon the surface of a ceramic chuck. More specifically, the invention is a protective coating and wafer spacing mask, and method of fabricating same, deposited upon the support surface of the ceramic chuck for preserving surface chemistry by sealing the support surface of the ceramic chuck from the atmosphere in the chamber. The protective coating is fabricated from a material that has superior non-reactive properties as compared to the ceramic chuck support surface material. Illustrative protective coating materials include tetraethyloxysilane (TEOS), silicon nitride (Si₃N₄), silicon dioxide (Si₂), silicon oxynitride (Si-O-N), boron nitride (BN), diamond, aluminum oxide (Al₂0₃), aluminium oxynitride (Al-O-N) and aluminosilicates (i.e. mullite, 3Al₂O₃2SiO₂). This coating prevents any further adsorption or reaction with contaminants in the atmosphere. The protective coating can also be formed by plasma etching the support surface of the ceramic chuck, then depositing a layer of the protective coating material. To maintain a wafer in a spaced-apart relation to the support surface, a spacing mask containing a plurality of support members is disposed atop the protective coating.

Using the protective coating and spacing mask of the present invention on the support surface of a ceramic chuck results in a substantial decrease in contamination of ceramic chucks, wafers and the process chamber environment. Specifically, the formerly exposed portion of the ceramic chuck is sealed from the process chamber environment. As such, it cannot react with or otherwise grow conductive films. Additionally, the spaced apart relationship of the wafer relative to the coated support surface via the spacing mask ensures that particle counts from contaminants or grains from the support surface are greatly reduced. Importantly, the protective coating does not significantly interfere with the clamping processor impact the clamping force that retains the wafer upon the electrostatic chuck. In this manner, contamination of the support surface of the ceramic chuck, the wafer and the process chamber are substantially reduced, while chuck performance is maintained.

### BRIEF DESCRIPTION OF THE DRAWINGS

The teachings of the present invention can be readily understood by considering the following detailed description in conjunction with the accompanying drawing, in which:
FIG. 1 depicts a vertical cross-section view of a ceramic electrostatic chuck containing the protective coating and wafer spacing mask of the present invention supporting a semiconductor wafer and,
FIG. 2 depicts a top view of the ceramic electrostatic chuck of FIG. 1 with the semiconductor wafer removed.

### DETAILED DESCRIPTION

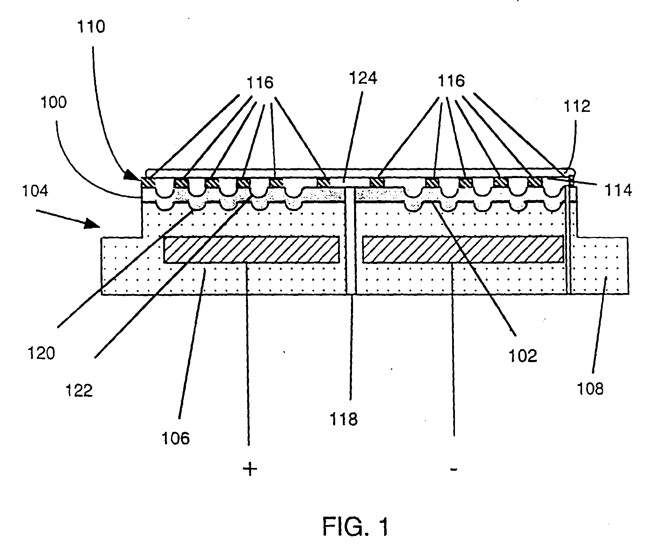

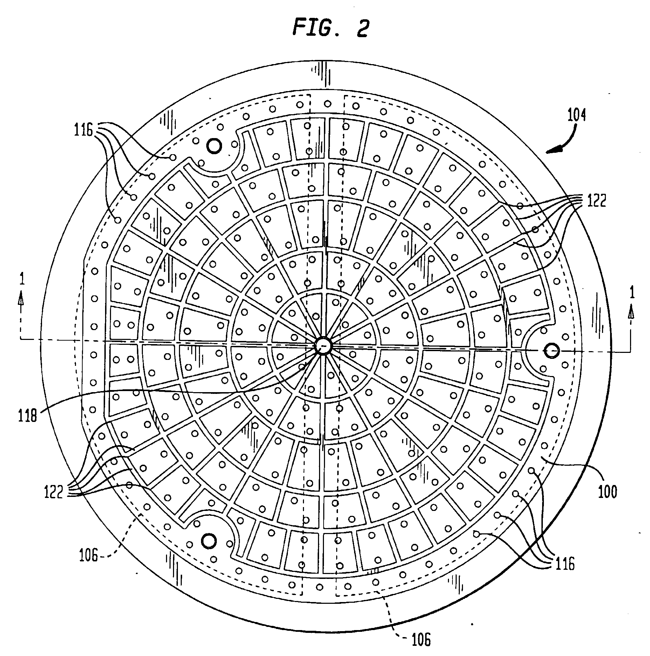

FIG. 1 depicts a vertical cross-sectional view of a ceramic electrostatic chuck 104 in accordance with the present invention. Specifically, the chuck 104 has a protective coating 100 disposed atop a support surface 102 and a wafer spacing mask 110 disposed atop the protective coating 100. To illustrate the use of the invention, FIG. 1 depicts a semiconductor wafer 112 supported by the chuck 104. FIG. 2 depicts a top view of the ceramic electrostatic chuck 104 of FIG. 1. The cross-section of FIG. 1 is taken along lines 1-1 of FIG. 2.

One important feature of the invention is that the protective coating 100 be fabricated from a material that has properties that are different from the support surface materials. Specifically, the material of the protective coating 100 is such that the material does not react with contaminants in the atmosphere, thus, preventing formation of a conductive film on the ceramic chuck. Consequently, the support surface 102 of the chuck 104 is, in essence, sealed from the process chamber environment. Additionally, the support surface 102 of the chuck 104 does not contact a backside 114 of the wafer 112.

In the preferred embodiment of the invention, a ceramic electrostatic chuck 104 is provided with a wafer spacing mask 110. Specifically, the spacing mask 110 comprises a plurality of individual support members 116 for maintaining the wafer 112 in a spaced apart relation to the support surface 102 and protective coating 100 of the electrostatic chuck 104. Ideally, the support members 116 are positioned on top of the protective coating 100. An illustrative ceramic electrostatic chuck containing such a wafer spacing mask is disclosed in commonly assigned U.S. Patent No. 5,656,093 issued August 12, 1997 and is herein incorporated by reference. In that disclosure, metallic material for the support members is deposited directly upon a support surface of an electrostatic chuck using a physical vapor deposition (PVD) process. The material may alternately be deposited using chemical vapor deposition (CVD), plasma spray deposition brazing, flame spray deposition and the like. Likewise, these same deposition techniques are available to deposit the support members 116 upon the protective coating 100 of the subject invention. Note that in FIG. 1, the support members 116 are shown in phantom as they do not appear in exactly these locations based upon the cross-section 1-1. Additionally, the proportions in FIG. 1 have been exaggerated and will be discussed in greater detail below.

The electrostatic chuck also contains one or more electrodes 106 embedded within a ceramic chuck body 108. A bipolar electrode configuration is depicted in FIGS. 1 and 2. A pair of electrodes is biased with equal and opposite polarity voltages to electrostatically clamp the wafer 112 to the chuck 104. Although a pair of D-shaped, bipolar electrodes is depicted, the electrode configuration may be any such configuration for clamping the wafer to the support surface including but not limited to monopolar, zonal bipolar (more than one set of bipolar electrodes) and the like. Additionally, electrodes may have various shapes including circular, interdigitated and the like.

The ceramic chuck body 108 is, for example, fabricated of aluminum nitride or boron nitride. Such leaky dielectric material provides superior chucking force during high-temperature processing of a semiconductor wafer. Other leaky dielectric materials (low resistivity) also form useful high temperature chuck materials such as alumina doped with titanium-oxide or chromium-oxide. If the chuck is to be used at low temperatures only, then other ceramic and/or dielectric materials such as alumina are used to form the chuck body.

To facilitate heat transfer from the wafer 112 to the chuck body 108, a heat transfer medium, e.g., a gas such as Argon, is pumped into interstitial spaces 124 between the backside 114 of the wafer 112 and the protective coating 100. This cooling technique is known as "backside gas cooling." The heat transfer medium is provided to the backside 114 of the wafer 112 via a port 118 that is formed through the chuck body 108 and the protective coating 100. The medium is typically supplied to the backside 114 of the wafer 112 at a rate of approximately 2 to 30 sccm. Such backside cooling is well known in the art and is disclosed, for example, in commonly assigned U.S. Patent 5,228,501 issued to Tepman, et al., on July 20, 1993.

A plurality of heat transfer medium distribution channels 120 may be formed in the chuck 104 to aid distribution of the heat transfer medium across the backside 114 of the wafer 112. The channels are typically cut into the support surface 102 of the chuck body 108 and the protective coating 100 coats the support surface 102 to produce a plurality of conformal channels 122 in the protective coating 100.

The protective coating 100 is deposited upon the support surface 102 of the chuck body 108 typically by plasma-enhanced chemical vapor deposition (CVD) of tetraethyloxysilane (TEOS). The protective coating 100 is evenly and conformally deposited across the entire support surface 102 of the chuck body 108. Other deposition techniques include sputtering, flame spraying and the like. The material of the protective coating has a superior non-reactive property as compared to the support surface material of the chuck. For example, the coating material is generally less abrasive and more compliant (e.g., produces less particles) than the support surface material. Alternative materials for the protective coating may be selected from the group consisting of oxides and nitrides and specifically include silicon nitride (Si₃N₄), silicon dioxide (SiO₂), silicon oxynitride (Si-O-N), boron nitride (BN), diamond, aluminum oxide (Al₂O₃), aluminum oxynitride (Al-O-N) and aluminosilicates (i.e. mullite, 3Al₂O₃2SiO₂). This coating prevents adsorption or reaction of the support surface 102 with contaminants in the atmosphere. After the protective coating 100 is deposited upon the support surface 102, the support member material is deposited atop the coating 100.

The protective coating 100 is deposited as a thin layer having a thickness, for example, in the range of approximately 50Å - 1µm. Such thinly deposited materials, especially ceramics, do not require lapping nor sintering and, as such, are not fractured or porous. Although a deposited coating of the same material as that of the chuck body 108 does not produce nor retain contaminant particles like the lapped support surface of the chuck body, such a surface does react with hydrocarbons and other such contaminants. As such, another material other than the material of the chuck body 108 is generally chosen for the protective coating 100. The marginal thickness of the protective coating 100 does not interfere or severely reduce the chucking force and facilitates conformal coating over the channels 120 in the support surface 102. For example, in a chuck using the Johnsen-Rahbek effect, charges, influenced by the potential difference between the electrodes 106, migrate through the leaky dielectric material of the chuck body 108. If the protective coating is also a leaky dielectric material, the charges also migrate through the protective coating 100. As such, a leakage current is formed that conducts to the support members 116. Since the protective coating 100 is below the level of the support members 116, the backside 114 of the wafer 112 only contacts the support members 116. If the channels 122 are cut into the protective coating 100, the thickness of the coating is usually thicker than the marginal thickness previously discussed and is in the range of approximately 50Å - 1µm. This extra thickness however does not compromise chucking performance. It should be noted that the dimensions of the protective coating 100 and channels 120 have been greatly exaggerated for easy viewing and understanding of the invention. Typically, the channels 120 formed in the chuck body 108 are approximately 50µm deep. As discussed, the protective coating 100 is approximately 50Å - 1µm thick. As such, when the protective coating is at its thinnest (∼50Å) the channels 120 are approximately 5 x 10⁵ deeper than the protective coating 100 is thick.

In another embodiment of the present invention, a thin layer (e.g., 0.02 - 0.04 µm) of the support surface 102 of the chuck 104 is removed prior to depositing the protective coating 100 or support members 116. Removal of a thin layer of the support surface 102 of the ceramic chuck 104 removes contaminants that may be sealed between the support surface 102 and the protective coating 100 which degrade chuck performance. The removal process can be performed by plasma etching (e.g., chemical oxidation or physical bombardment via working gas ions such as Ar⁺), ozone cleaning and the like. After the thin layer of the ceramic chuck is etched, a protective coating is deposited and then the support member material is deposited.

Using the protective coating of the present invention on the support surface of a ceramic chuck results in a substantial decrease in contamination of ceramic chucks, wafers and the process chamber environment. Importantly, the protective coating does not significantly interfere with the clamping process or impact the clamping forge that retains the wafer upon the electrostatic chuck.

Although various embodiments which incorporate the teachings of the present invention have been shown and described in detail herein, those skilled in the art can readily devise many other varied embodiments that still incorporate these teachings.

## Claims

1. Apparatus for protecting a substrate and a support surface of a ceramic substrate support chuck comprising:
a protective coating (100), deposited upon the support surface (102), for isolating said substrate from said support surface and isolating said support surface from an atmosphere proximate said support surface; and
a wafer spacing mask (110) disposed upon the protective coating (100).

2. The apparatus of claim 1 wherein said protective coating (100) is a ceramic.

3. The apparatus of claim 2 wherein said ceramic is selected from the group consisting of oxides, nitrides, silicon nitride (Si₃N₄), silicon dioxide (SiO₂), silicon oxynitride (Si-O-N), boron nitride (BN), diamond, aluminum oxide (Al₂O₃), aluminum oxynitride (Al-O-N) and aluminosilicates (i.e. mullite, 3Al₂O₃2SiO₂).

4. The apparatus of claim 2 wherein said ceramic is a leaky dielectric.

5. The apparatus of claim 2 wherein the protective coating (100) is deposited via plasma-enhanced CVD of TEOS.

6. The apparatus of claim 5 wherein the protective coating (100) is approximately in the range of 50Å - 1µm thick.

7. The apparatus of claim 1 wherein the wafer spacing mask (110) further comprises a plurality of support members (116).

8. Apparatus for supporting a workpiece comprising:
a ceramic electrostatic chuck (104) having a plurality of electrodes (106) embedded beneath a support surface (102);
a protective coating (100), disposed upon said support surface (102) of said ceramic electrostatic chuck (104); and
a wafer spacing mask (110) disposed upon the protective coating (100).

9. The apparatus of claim 8 wherein said protective coating (100) is a ceramic.

10. The apparatus of claim 9 wherein said ceramic is selected from the group consisting of oxides, nitrides, silicon nitride (Si₃N₄), silicon dioxide (SiO₂), silicon oxynitride (Si-O-N), boron nitride (BN), diamond, aluminum oxide (Al₂O₃), aluminmn oxynitride (Al-O-N) and aluminosilicates (i.e. mullite, 3Al₂O₃2SiO₂).

11. The apparatus of claim 9 wherein said ceramic is a leaky dielectric at temperatures above approximately 300°C.

12. The apparatus of claim 9 wherein the protective coating (100) is deposited via a plasma-enhanced CVD of TEOS.

13. The apparatus of claim 12 wherein the protective coating (100) is approximately in the range of 50Å - 1µm thick.

14. The apparatus of claim 8 wherein the wafer spacing mask (110) further comprises a plurality of support members (116).

15. A metbod of fabricating a ceramic substrate support chuck comprising the steps of:
providing a ceramic chuck body (108) having support surface (102);
depositing a leaky dielectric material over the support surface (102) of said ceramic chuck body (108) to form a protective coating (100); and
depositing a wafer spacing mask (110) upon the protective coating (100).

16. The method of claim 15 wherein said leaky dielectric is partially conductive at temperatures above approximately 300°C.

17. The method of claim 15 wherein said leaky dielectric is selected from the group consisting of oxides, nitrides, silicon nitride (Si₃N₄), silicon dioxide (SiO₂), silicon oxynitride (Si-O-N), boron nitride (BN), diamond, aluminum oxide (Al₂O₃), aluminum oxynitride (Al-O-N) and aluminosilicates (i.e. mullite, 3Al₂O₃2SiO₂).

18. The method of claim 15 wherein the step of depositing the leaky dielectric is performed via a plasma-enhanced CVD of TEOS.

19. The method of claim 18 wherein the protective coating (100) is approximately in the range of 50Å - 1µm thick.

20. The method of claim 15 wherein the step of depositing a wafer spacing mask (110) further comprises depositing individual support members (116).

21. The method of claim 15 further comprising, prior to said leaky dialectric deposition step:
removing a layer of said support surface (102).
